# EUROPÄISCHE PATENTSCHRIFT

(11) **EP 0 528 239 B1**
(45) Veröffentlichungstag und Bekanntmachung des Hinweises auf die Patenterteilung: **27.12.1995**
(21) Anmeldenummer: 92113153.8
(22) Anmeldetag: 01.08.1992
(51) Int. Cl.: H05K 7/18, H05K 5/00, H05K 9/00

(54) **Geräteschrank**
Equipment cabinet
Boîtier pour appareillage

(30) Priorität: 20.08.1991 DE 4127467
(43) Veröffentlichungstag der Anmeldung: 24.02.1993
(73) Patentinhaber: Schroff GmbH, D-75334 Straubenhardt (DE); SIEMENS AKTIENGESELLSCHAFT, 80333 München (DE)
(72) Erfinder: Schwenk, Hans Martin, Ing.(grad.), W-7541 Straubenhardt 2 (DE); Pohl, Kurt, Dipl.-Ing. (FH), W-8000 München 83 (DE); Hüller, Gerhard, Dipl.-Ing. (FH), W-8175 Reichersbeuern (DE)
(74) Vertreter: Durm, Klaus, Dr.-Ing.

(56) Entgegenhaltungen:
- EP-A- 0 210 525
- US-A- 4 068 087

## Beschreibung

Die Erfindung betrifft einen Geräteschrank für elektrische und elektronische Einschubgeräte, mit einem Gestell zur Halterung der Einschubgeräte, an dem Gestell befestigten Verkleidungsteilen sowie mit wenigstens einer Tür, die mittels Scharnieren schwenkbar angeschlagen ist.

Derartige Geräteschränke dienen der Aufnahme von elektronischen Geräten, die als genormte Baugruppen im Rastermaß aufgebaut sind. Durch eine öffenbare Tür sind die eingebauten Baugruppen jederzeit leicht zugänglich, beispielsweise zu Wartungszwecken. Bei größeren Geräteschränken bildet die Tür gleichzeitig die Schrankfront und ist mittels Scharnieren seitlich so angeschlagen, daß sie durch Verschwenken um die Scharnierachse von vorne geöffnet werden kann.

Der Geräteschrank hat unter anderem auch die Aufgabe, die in seinem Inneren installierten elektronischen Geräte gegen störende Umwelteinflüsse zu schützen. Hierzu gehören sowohl Staub und Feuchtigkeit, wie sie insbesondere im Produktionsbereich unvermeidlich sind, als auch hochfrequente Störstrahlungen durch andere, unzureichend abgeschirmte elektronische Geräte. Während eine ausreichende mechanische und hochfrequenzmäßige Abdichtung der Spalte zwischen den fest am Gestell montierten Verkleidungsteilen in der Regel keine Schwierigkeiten bereitet, stellt eine zuverlässige und langlebige Abdichtung des umlaufenden Spaltes zwischen der schwenkbaren Tür und den dieser gegenüberliegenden festen Verkleidungsteilen ein besonderes Problem dar. Üblich sind Gummidichtungen zum Schutz gegen Staub und Feuchtigkeit sowie Kontaktstreifen aus elektrisch gut leitfähigem und zugleich federelastischem Material zur Abschirmung gegen hochfrequente elektromagnetische Wellen.

Bei erhöhten Anforderungen an die mechanische und/oder hochfrequenzmäßige Dichtigkeit stellt sich gerade bei großen Geräteschränken mit entsprechend großflächigen Fronttüren das Problem, daß eine mit entsprechenden Dichtungen versehene Tür nur noch mit großem Kraftaufwand geschlossen werden kann. Dies führt in der Praxis dann oft dazu, daß die schwergängige oder gar klemmende Tür nach einem Kontroll- oder Wartungsvorgang nicht mehr vollständig oder sogar überhaupt nicht mehr geschlossen wird, wodurch jeder konstruktive Aufwand zur Erzielung einer guten Abdichtung des Schrankinnenraums zunichte gemacht wird.

Aufgabe der Erfindung ist deshalb die Schaffung eines mit einer schwenkbaren Tür versehenen Geräteschrankes, der hinsichtlich der Abdichtung seines Innenraums hohen Anforderungen gerecht wird, bei dem jedoch gleichzeitig die Tür ohne großen Kraftaufwand korrekt geschlossen werden kann.

Bei der Lösung dieses technischen Problems wird ausgegangen von einem Geräteschrank der eingangs erwähnten Art. Gelöst wird die Aufgabe dadurch, daß die Tür und die dieser gegenüberliegenden Stirnseiten der Verkleidungsteile jeweils mit ringsumlaufenden Randleisten versehen sind, daß diese Randleisten jeweils unter Bildung von spitzen Winkeln gegenüber den Hauptflächen der Tür bzw. der Verkleidungsteile nach innen abgebogen sind, wobei diese Winkel an den jeweils zusammenstoßenden Rändern der Tür und der Verkleidungsteile sich einander zu 90 Grad ergänzen, daß ferner die Randleisten sich parallel in geringem Abstand gegenüberliegende Dichtflächen tragen, und daß schließlich zwischen diesen Dichtflächen der Randleisten federelastische Dichtungen vorgesehen sind.

Bei dem erfindungsgemäßen Geräteschrank verlaufen die Dichtflächen für die Dichtungen unter einem spitzen Winkel gegenüber der Türfläche bzw. dem jeweiligen Verkleidungsteil. Die von den federelastischen Dichtungen auf diese schrägen Dichtflächen ausgeübten Federkräfte wirken senkrecht zu den Dichtflächen und damit ebenfalls unter dem entsprechenden Winkel gegenüber den Ebenen der Tür bzw. der anstoßenden Verkleidungsteile ein. Aus diesem Grunde muß beim Zudrücken der Tür nicht mehr die gesamte Federkraft der umlaufenden Türdichtungen überwunden werden, sondern nur noch der zur Schließrichtung parallele Kraftanteil. Die von den federelastischen Dichtungen ausgeübten Kräfte lassen sich nämlich vektoriell in eine erste Kraftkomponente in Schließrichtung und in eine zweite Kraftkomponente quer dazu, also parallel zur Türfläche zerlegen. Letztere Kraftkomponente muß aber beim Zudrücken jedoch nicht überwunden werden, da sie von den Türscharnieren aufgenommen wird. Der Vorteil dieser Konstruktion liegt darin, daß die zum Schließen der Tür aufzuwendende Kraft erheblich geringer ist als bei herkömmlichen Dichtungsanordnungen mit parallel bzw. senkrecht angeordneten Dichtflächen.

Bevorzugt sind die Randleisten unter einem Winkel von 45 Grad nach innen abgebogen. Die aufzuwendende Schließkraft reduziert sich dann ungefähr um den Faktor 0,7.

Mit der vorgeschlagenen Lösung lassen sich sowohl die Dichtigkeit des Geräteschranks gegen Staub und Feuchtigkeit als auch gegen hochfrequente elektromagnetische Wellen verbessern. Als Dichtungen kommen somit Kontaktstreifen aus elektrisch gut leitfähigem Material, beispielsweise in Form von Federkontakten oder federelastischen Metallgeflechten, ebenso in Betracht wie gummielastische Dichtungsleisten.

Ein weiterer großer Vorteil der erfindungsgemäßen Kontruktion ist die Möglichkeit, mechanische Dichtungsleisten und HF-Dichtungen parallel nebeneinander vorzusehen, ohne daß der Kraftaufwand beim Schließen einer so abgedichteten Tür zu groß werden würde. Bevorzugt lassen sich Kontaktstreifen aus elektrisch gut leitfähigem Material, die der HF-Abdichtung dienen, mit parallel daneben angeordneten, gummielastischen Dichtungsleisten, welche gegen Staub und Feuchtigkeit abdichten, kombinieren.

Ein Ausführungsbeispiel der Erfindung wird nachstehend anhand der beigefügten Zeichnungen näher erläutert. Es zeigen:
- Figur 1: einen Geräteschrank mit einer frontseitigen Tür, in vereinfachter perspektivischer Darstellung;
- Figur 2: einen Horizontalschnitt durch die rechte vordere Ecke des Geräteschranks von Figur 1, in vergrößertem Maßstab.

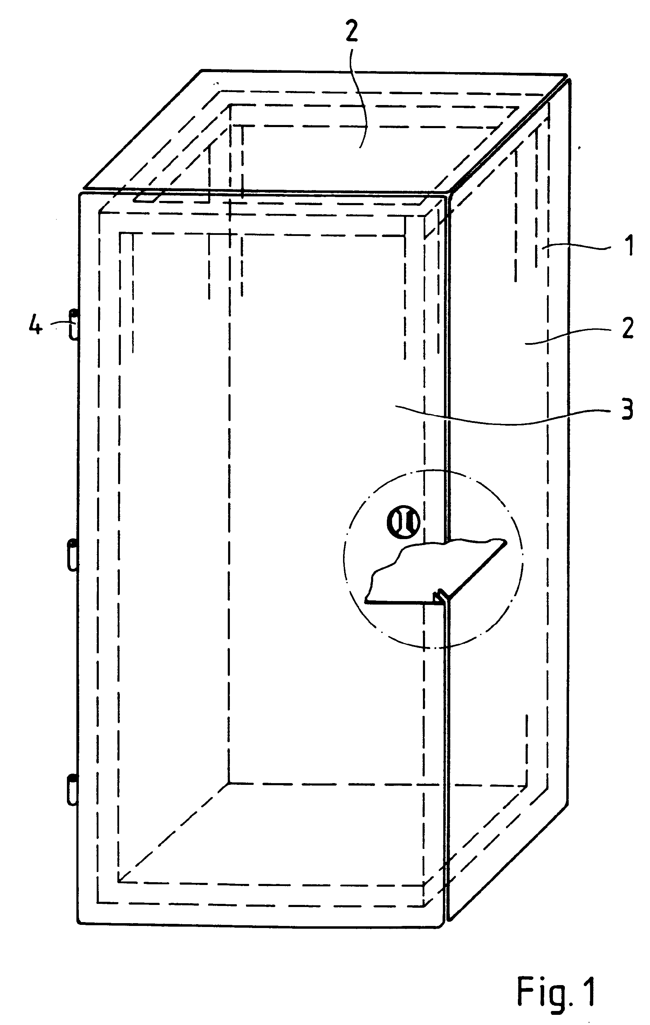

Der in Figur 1 in geschlossenem Zustand dargestellte Geräteschrank hat als tragende Struktur ein Gestell 1, das ihm die erforderliche Festigkeit und Steifigkeit verleiht und zur Halterung von (nicht dargestellten) elektrischen und elektronischen Einschubgeräten dient. An dem Gestell 1 sind aus Metallblech gefertigte Verkleidungsteile 2 fest anmontiert, welche Rückwand, Seitenteile, Dach und Boden des Geräteschranks bilden. An der Frontseite ist eine ebenfalls aus Blech bestehende Tür 3 mittels Scharnieren 4 schwenkbar angeschlagen.

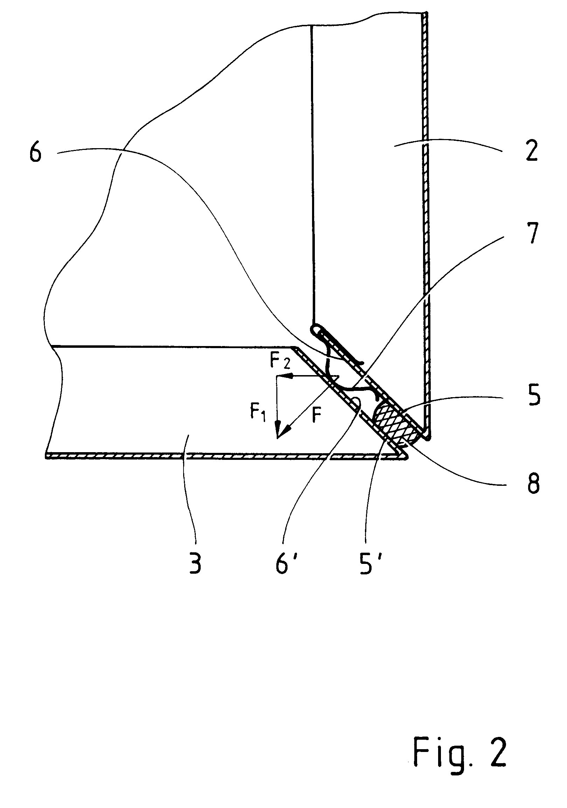

Wie insbesondere aus der vergrößerten Schnittzeichnung in Figur 2 ersichtlich ist, sind sowohl die Tür 3 als auch die dieser gegenüberliegenden Stirnseiten der Verkleidungsteile 2 jeweils mit umlaufenden Randleisten 5 bzw. 5′ versehen, welche jeweils unter einem Winkel von ungefähr 45 Grad nach innen abgebogen sind. Diese Randleisten 5, 5′ tragen Dichtflächen 6 bzw. 6′, die sich parallel in geringem Abstand gegenüberliegen.

Zwischen den Dichtflächen 6, 6′ an den Randleisten 5, 5′ sind federelastische Dichtungen vorgesehen, wobei diese Dichtungen hier einen metallisch gut leitfähigen und aus Reihen von Federkontakten bestehenden Kontaktstreifen 7 sowie eine parallel daneben angeordnete Dichtungsleiste 8 aus gummielastischem Material umfassen. Kontaktstreifen 7 und Dichtungsleiste 8 laufen dabei rings um den Rahmen der Tür 3, so daß in geschlossenem Zustand eine vollständige Abdichtung der Tür 3 gegenüber den feststehenden Verkleidungsteilen 2 sowohl gegen Staub und Feuchtigkeit als auch gegen hochfrequente Störstrahlung erzielt wird.

In Figur 2 ist beispielhaft für die gummielastische Dichtungsleiste 8 die Aufspaltung der Federkraft F in die beiden Kraftkomponenten F₁ und F₂ angegeben. Dabei ist die Kraftkomponente F₁ senkrecht und die Kraftkomponente F₂ parallel zur Ebene der Tür 3 gerichtet. Beim Schließen der Tür 3 muß nur die senkrechte Kraftkomponente F₁ überwunden werden, während die parallele Kraftkomponente F₂ von den Scharnieren 4 (vergleiche Figur 1) aufgenommen wird.

### Verzeichnis der Bezugsziffern

- 1: Gestell
- 2: Verkleidungsteile
- 3: Tür
- 4: Scharniere (von 3)
- 5, 5′: Randleisten (von 2, 3)
- 6, 6′: Dichtflächen (an 5, 5′)
- 7: Kontaktstreifen
- 8: Dichtungsleiste

- F: Federkraft
- F₁, F₂: Kraftkomponenten (von F)

## Patentansprüche

1. Geräteschrank für elektrische und elektronische Einschubgeräte, mit
- einem Gestell (1) zur Halterung der Einschubgeräte;
- an dem Gestell (1) befestigten Verkleidungsteilen (2);
- wenigstens einer Tür (3), die mittels Scharnieren (4) schwenkbar angeschlagen ist;
dadurch **gekennzeichnet**, daß
- die Tür (3) und die dieser gegenüberliegenden Stirnseiten der Verkleidungsteile (2) jeweils mit ringsumlaufenden Randleisten (5, 5′) versehen sind;
- die Randleisten (5, 5′) jeweils unter Bildung von spitzen Winkeln gegenüber den Hauptflächen der Tür (3) bzw. der Verkleidungsteile (2) nach innen abgebogen sind, wobei diese Winkel an den jeweils zusammenstoßenden Rändern der Tür (3) und der Verkleidungsteile sich einander zu 90 Grad ergänzen;
- die Randleisten (5, 5′) sich parallel in geringem Abstand gegenüberliegende Dichtflächen (6, 6′) tragen;
- zwischen den Dichtflächen (6, 6) der Randleisten (5, 5′) federelastische Dichtungen vorgesehen sind.

2. Geräteschrank nach Anspruch 1, dadurch **gekennzeichnet**, daß die spitzen Winkel, unter denen die Randleisten (5, 5′) abgebogen sind, jeweils ungefähr 45 Grad betragen.

3. Geräteschrank nach Anspruch 1 oder 2, dadurch **gekennzeichnet**, daß die Dichtungen Kontaktstreifen (7) aus elektrisch gut leitfähigem Material sind.

4. Geräteschrank nach Anspruch 3, dadurch **gekennzeichnet**, daß die Kontaktstreifen (7) aus Reihen von nebeneinander angeordneten Federkontakten bestehen.

5. Geräteschrank nach Anspruch 3, dadurch **gekennzeichnet**, daß die Kontaktstreifen (7) aus federelastischem Metallgeflecht bestehen.

6. Geräteschrank nach Anspruch 1 oder 2, dadurch **gekennzeichnet**, daß die Dichtungen gummielastische Dichtungsleisten (8) sind.

## Claims

1. An appliance cabinet for electrical and electronic slide-in appliances, with
- a frame (1) for mounting the slide-in appliances;
- enclosure parts (2) secured to the frame (1);
- at least one door (3) pivotally mounted by means of hinges (4);
**characterised in that**
- the door (3) and the front sides of the enclosure parts (2) lying opposite thereto are respectively provided with peripherally extending edge bars (5, 5′);
- the edge bars (5, 5′) are each bent inwardly under the formation of acute angles relative to the main surfaces of the door (3) and the enclosure parts (2) respectively, wherein these angles complement each other to 90° at the respective abutted edges of the door (3) and the enclosure parts;
- the edge parts (5, 5′) carry parallel mutually slightly spaced opposed sealing surfaces (6, 6′);
- resilient seals are provided between the sealing surfaces (6, 6′) of the edge bars (5, 5′).

2. Appliance cabinet according to claim 1,
**characterised in that**
the acute angles under which the edge bars (5, 5′) are bent each amount to approximately 45°.

3. Appliance cabinet according to claim 1 or 2,
**characterised in that**
the seals are contact strips (7) made of a material which is a good electrical conductor.

4. Appliance cabinet according to claim 3,
**characterised in that**
the contact strips (7) consist of rows of spring contacts arranged next to each other.

5. Appliance cabinet according to claim 3,
**characterised in that**
the contact strips (7) consist of resilient metallic braid.

6. Appliance cabinet according to claim 1 or 2,
**characterised in that**
the seals are elastomeric resilient sealing bars (8).

## Revendications

1. Armoire pour appareils électriques et électroniques en tiroirs, comportant
- un bâti (1) destiné à supporter les appareils en tiroirs,
- des éléments de revêtement (2) fixés à ce bâti (1),
- au moins une porte (3) montée sur des charnières (4),
caractérisée en ce que
- la porte (3) et les côtés frontaux faisant face à celle-ci des éléments de revêtement (2) sont pourvus chacun de rebords (5, 5′) faisant tout le tour,
- ces rebords (5, 5′) sont rabattus vers l'intérieur de façon à faire des angles aigus avec les faces principales de la porte (3) ou des éléments de revêtement (2), ces angles se complétant à 90° aux bords contigus de la porte (3) et des éléments de revêtement,
- les rebords (5, 5′) portent des surfaces d'étanchéité (6, 6′) se faisant face et parallèles situées à une faible distance l'une de l'autre,
- entre ces surfaces d'étanchéité (6, 6′) des rebords (5, 5′) sont prévus des joints d'étanchéité élastiques.

2. Armoire pour appareils selon la revendication 1, caractérisée en ce que les angles aigus auxquels sont rabattus les rebords (5, 5′) sont chacun d'environ 45 degrés.

3. Armoire pour appareils selon l'une des revendications 1 et 2, caractérisée en ce que les joints d'étanchéité sont des bandes de contacts (7) en matière bonne conductrice de l'électricité.

4. Armoire pour appareils selon la revendication 3, caractérisée en ce que les bandes de contacts (7) sont constituées de rangées de contacts à ressort placés les uns à côté des autres.

5. Armoire pour appareils selon la revendication 3, caractérisée en ce que les bandes de contacts (7) sont constituées de treillis métallique élastique.

6. Armoire pour appareils selon l'une des revendications 1 et 2, caractérisée en ce que les joints d'étanchéité sont des baguettes d'étanchéité (8) ayant l'élasticité du caoutchouc.
